# EUROPEAN PATENT SPECIFICATION

(11) **EP 2 789 019 B1**
(45) Date of publication and mention of the grant of the patent: **01.02.2017**
(21) Application number: 12806247.8
(22) Date of filing: 03.12.2012
(51) Int. Cl.: H01L 31/05, H01L 27/142

(54) **A PHOTOVOLTAIC ARTICLE COMPRISING A PHOTOVOLTAIC CELL WITH ELECTRICAL CONNECTION ELEMENTS**
PHOTOVOLTAISCHE EINRICHTUNG UMFASSEND EINE PHOTOVOLTAISCHE ZELLE MIT ELEKTRISCHEN ANSCHLUSSELEMENTEN
UN ARTICLE PHOTOVOLTAÏQUE COMPRENANT UNE CELLULE PHOTOVOLTAÏQUE AVEC ELEMENTS DE CONNEXION ÉLECTRIQUE

(30) Priority: 08.12.2011 US 201161568192 P
(43) Date of publication of application: 15.10.2014
(73) Proprietor: Dow Global Technologies LLC, Midland, MI 48674 (US)
(72) Inventor: DEGROOT, Marty W., Middletown, DE 19709 (US); CLARK, Lindsey A., Midland, MI 48642 (US)
(74) Representative: Beck Greener
(86) International application number: PCT/US2012/067544
(87) International publication number: WO 2013/085829

(56) References cited:
- WO-A1-2011/024662
- GB-A- 1 333 593

## Description

### Field of the Invention

This invention relates generally to interconnected photovoltaic cells and modules and particularly to an improved approach to maintaining good interconnect performance throughout useful life of the cells or module.

### Introduction

Photovoltaic cells typically comprise a photoactive portion that converts light energy to electricity. On the backside of these cells is found a backside electrode and on the front side another electrical collection system. It is common for these cells to be connected in series by multiple thin interconnect wires or ribbons that contact the front side of a first cell and the back side on an adjacent cell to form a string of solar cells. One common interconnect configuration employs flat wire ribbons that connect to the top electrical collection system of one cell, typically on a buss line that is part of an electrically conductive grid deposited on the top electrode of the cell. The flat wire ribbon is then extended to contact the backside electrode of an adjacent cell. This configuration is commonly referred to as 'string & tab'. In order to ensure that the ribbons maintain electrical contact with both the frontside and backside electrodes, it is common that an electrically conductive adhesive (ECA) or solder is used to attach the interconnect ribbon to the front and back sides of the adjacent cells.

These interconnect configurations are commonly used with both rigid and flexible photovoltaic cells such as copper chalcogenide type cells (e.g. copper indium gallium selenides, copper indium selenides, copper indium gallium sulfides, copper indium sulfides, copper indium gallium selenides sulfides, etc.), amorphous silicon cells, crystalline silicon cells, thin-film III-V cells, organic photovoltaics, nanoparticle photovoltaics, dye sensitized solar cells, and combinations of the like.

WO 2009/097161 teaches strings of cells that are electrically joined by conductive tabs or ribbons adhered with an electrically conductive adhesive on the front and back of adjacent cells and further teaches that the back of the substrate can be coated with a layer of Mo or Cr/Mo. WO 2009/097161 further teaches that the thermal expansion coefficient of the ribbon material should be less than 20% different versus that of the substrate in order to avoid expansion coefficient mismatch that may lead to failure. Typical examples of interconnect ribbons used in this type of application include metal ribbons that are coated with Sn or a Sn/Ag alloy.Other examples of approaches to interconnection include US 2009/0266398, US 2009/0260675, U.S. 7,732,229, US 2005/0263179, US 2008/0216887, US 2009/00025788, US 2008/0011350, US 7,432,438, US 6,936,761; US 2007/0251570 and US.S. 7,022,910.

The industry continues to examine alternative approaches to improve interconnection.

### Summary of Invention

The present inventors have discovered that electrical contacts in the interconnected cell string are susceptible to increased electrical resistance after environmental exposure. The inventors have further discovered that such increase in resistance can be avoided or substantially reduced by proper selection of metal elements used in the interconnected cell string.

Thus, according to a first embodiment, the invention is a photovoltaic article comprising:
an electrically conductive substrate serving as a backside electrode for the photovoltaic cell,
a photoactive portion on a frontside of the substrate, wherein the photoactive portion comprises a IB-IIIA chalconide, and a front side electrical collection system on the opposite side of the photoactive portion from the substrate,
wherein the backside of the substrate is plated with a metal which forms the backside surface of the substrate;
at least one first electrical connection element having an outer surface which element is electrically connected to a backside surface of the substrate
at least one second electrical connection element having an outer surface which element is electrically connected to the front side electrical collection system,
wherein the metal that forms the backside surface of the substrate, any metal surfaces that are part of the electrical collection system, and the outer surfaces of the electrical connection elements each are formed from materials each having an electric potential that differs from the electric potential of the material used on the other surfaces by no greater than 0.1 V, preferably no greater than 0.05 V (i.e. the electric potentials of the materials used for each of the backside surface of the substrate and the outer surfaces of the electrical connection elements, and, if it is metallic the top surface of the front side electrical collection system each differ from each other by no greater than 0.1 V).

### Brief Description Of the Drawings

Fig. 1 is a schematic showing the frontside view of a representative electrical connection from one photovoltaic cell to an adjacent photovoltaic cell.
Fig. 2 is a schematic of a cross-section showing a representative electrical connector from one cell to an adjacent cell.

### Detailed Description

The present invention requires that the surfaces of the electrically conductive components of the electrical collection and interconnection system of the inventive photovoltaic article be selected to minimize or eliminate the galvanic corrosion potential in the system. The electrical collection and interconnection system of typical solar cells known in the art are typically designed with metals that are dissimilar enough to be favorable for galvanic corrosion to occur. That is, the standard electric potential, or standard electrode potential (herein referred to as electric potential) of the two interfacing materials is significantly different such that galvanic corrosion may be possible or even favorable. The standard electrode potential of a given material is the measure of individual potential of a reversible electrode under standard conditions relative to the standard calomel electrode (SCE). As an example, most often the electrical interconnection of crystalline silicon solar cells within a photovoltaic module is made by soldering of tin coated ribbons to a Ag containing screen-printed busbar. As described above, it is common that the backside electrical connection of thin film cells consists of a Sn coated interconnect ribbon in electrical contact with a stainless steel or Mo back contact. According to published electrical potential data, the galvanic corrosion potential of the Mo/Sn or Ag/Sn system may be greater than about 0.2V and may lead to galvanic corrosion at the interfaces.

Thus, as noted above, the electric potential of the materials used in exposed metal surfaces in the photovoltaic article of this invention are each within 0.1 V, preferably within 0.05 V, of the electric potential of the materials used in the other exposed metal surfaces to which they are electrically connected. Most preferably, the metal surfaces are made of the same metal or same metal alloy. Standard electric potential values for several metals and alloys may be found from several sources such as the CRC Handbook of Chemistry and Physics or ASTM G82-98.

In the broadest embodiment, the invention may be a single cell with the outer surface of the backside electrode, and the outer surface of the electrical connection elements being made of materials having a difference in electric potential of 0.1 V, preferably 0.05 V, or less. Preferably, the front side electrical collection system also is a metal or metal alloy having an outer surface made from a material having an electric potential within 0.1 V, preferably 0.05 V, of the materials used in the outer surface of the backside electrode and the outer surface of the electrical connectioni elements. Preferably, the electrical connection elements are joined to at least one of the backside electrode or the frontside electrical collection system using an electrically conductive adhesive. Such adhesives comprise metal particles in a polymeric matrix. The metal particles are selected such that the metal or metal alloy comprising their outer surface has an electric potential within 0.1V preferably 0.05 V, of the materials used on the other elements (backside electrode surface, electrical connection elements, and, optionally, front side electrical collection system). Preferably, the invention comprises at least two cells located adjacent to one another where the electrical connection element joine to the the front side electrical collection system of one cell is joined to the backside electrode of the adjacent cell.

Most preferably, the metals in each of the exposed metal components is the same as that used in the other exposed metal components.

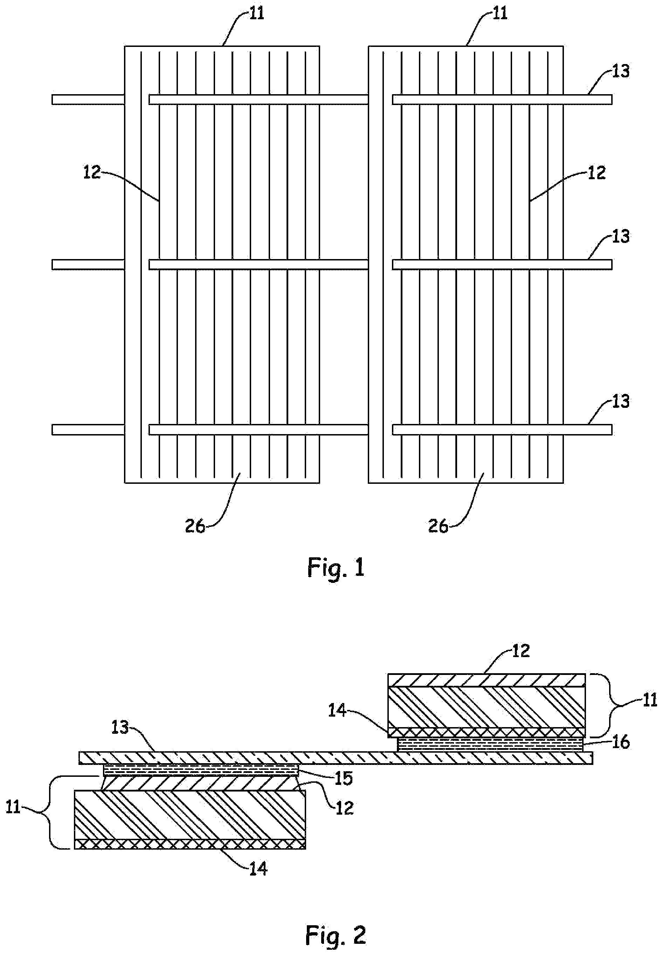

Fig. 1 shows a frontside view of an exemplary embodiment of the photovoltaic article of this invention in this case showing two adjacent photovoltaic cells 11. Fig. 2 shows a cross section at the location of two interconnected cells. Each cell has a backside electrode 14 and a frontside electrical collection system, in this case shown as a collection grid 12 consisting of a series of thin wires or electrically conductive material serving as an electrical collector, located on a frontside transparent electrical contact 26 (region between the grid 12). According to one approach, the frontside electrical collector can extend beyond the edge of the first cell to contact the backside of the second cell. In this approach the electrical collection system also serves as the cell to cell electrical connector. This approach is not shown in Figs.1 and 2. Alternatively, as shown in Figs. 1 and 2 a separate electrical connection element (also referred to herein as interconnect element) 13, in this case a conductive ribbon, is provided to connect the frontside electrical collection system 12 of the first cell to the backside electrode 14 of the second cell. In other embodiments, the conductive ribbon(s) may be substituted for thin wires or wire mesh, in each case comprising of or being coated or plated with an appropriate metallurgy consistent with the abovementioned invention. An electrically conductive bonding element, such as electrically conductive adhesives (ECA) 15 and 16 can be used to adhere the interconnect element 13 to the front and backside electrodes of the cell. Additional cells may be added to form a string of the length desired; the terminal cells will have electrical leads (not shown) provided to enable connection of the cell into a more complex array (formed by modules made of the subject string) or to an electric service system.

The collection grid 12, interconnect elements 13, backside electrode 14 and the conductive adhesives 15 and 16, together make up the electrical collection and interconnection system of the solar cell string or module. The surfaces of the electrically conductive components 12-16 of the electrical collection and interconnection system are metal components with electrical potential values that are separated by less than 0.1V, preferably less than 0.05 V, and most preferably are the same metal or same metal alloy. In this fashion, this interconnect configuration reduces or eliminates the potential for galvanic corrosion at interfaces between dissimilar metals used in the components 12-16. For example, the electrical connection element and back surface of the backside electrode may be entirely a single metal or may be all plated with similar metals. Similarly if a bonding element, such as a weld or an electrically conductive adhesive is used, the weld material or the surface metal of the conductive particles in the ECA should be selected to correspond to the materials in the electrical connection element and back surface of the backside electrode. As a non-limiting example, the backside electrode and electrical connection elements may be plated with silver. In that case, any metallic frontside electrical collection system 12 should also be silver or silver plated, or be comprised of silver particles, and conductive particles in any ECA 15 or 16 should be silver or weld material should be silver. In an embodiment where a conductive patch is used over the contact between the electrical connection element and the backside electrode, that patch also preferably comprises the same metallurgy. Discussion of materials below should be read in the context of understanding that selection should be made such that all exposed metals are the same, or have electrical potential differences less than 0.1 V.

Typically the backside electrode 14 will comprise a conductive substrate layer of metal foils or films or will be such a foil, film or a metal paste or coating on a nonconductive or conductive substrate. Suitable materials include, but are not limited to metal foils or films of stainless steel, aluminum, titanium or molybdenum. Stainless steel and titanium are preferred. Preferably, the backside electrode structure including the substrate is flexible. The conductive substrate layer can be coated with optional backside electrical contact regions on one or both sides. Such regions may be formed from a wide range of electrically conductive materials, including one or more of Cu, Mo, Ag, Al, Cr, Ni, Ti, Ta, Nb, W combinations of these, and the like. Conductive compositions incorporating Mo may be used in an illustrative embodiment. To avoid galvanic corrosion, the backside surface of the backside electrode is plated with the metal used in the electrical connection element. In preferred embodiments this metal is silver. In some cases, the backside electrode of the cell may become contaminated with elements that are used in the cell manufacturing process. The backside electrode may be directly plated with the metal used in the electrical connection element, or an additional process to eliminate the backside contaminants may be carried out. Options include plasma treatment or mechanical cleaning of the back surface prior to deposition of the metal used in the electrical connection element. The inventors have found that a plasma treatment process may also be useful in improving the initial resistance of the backside electrical contact.

The photovoltaic cells 11 used in this invention comprise as a photoactive layer a layer of IB-IIIA-chalcogenide, such as IB-IIIA-selenides, IB-IIIA-sulfides, or IB-IIIA-selenide sulfides. More specific examples include copper indium selenides, copper indium gallium selenides, copper gallium selenides, copper indium sulfides, copper indium gallium sulfides, copper gallium sulfides, copper indium sulfide selenides, copper gallium sulfide selenides, and copper indium gallium sulfide selenides (all of which are referred to herein as CIGSS). These can be represented by the formula CuIn(1-x)GaxSe(2-y)Sy where x is 0 to 1 and y is 0 to 2. The copper indium selenides and copper indium gallium selenides are preferred. This layer may be called the absorber layer. The absorber may be formed by any suitable method using a variety of one or more techniques such as evaporation, sputtering, electrodeposition, spraying, and sintering (Dhere, Solar Energy Materials & Solar Cells 90 (2006) 2181-2190.)

CIGSS cells usually include additional electroactive layers such as one or more of emitter (buffer) layers, conductive layers (e.g. transparent conductive layer used on the top side) and the like as is known in the art to be useful in CIGSS based cells are also contemplated herein. The emitter or buffer layer is an n-type semiconductor, such as for example CdS, that forms a pn junction with the absorber. It is known that buffer layers such as CdS layers can be formed on various substrates by chemical bath deposition, physical vapor deposition or sputtering. See e.g. Abou-Ras et al (Thin Solid Films 480-481 (2005) 118-123) and 5,500,055. Cells with no buffer or alternative materials for buffer are also known and can be used in this invention.

An optional window region, which may be a single layer or formed from multiple sublayers via techniques including sputtering and MOCVD, can help to protect against shunts. This region also may protect the buffer region during subsequent deposition of the transparent conductive layer which serves as part or all of the frontside electrical collection system. The window region may be formed from a wide range of materials and often is formed from a resistive, transparent oxide such as an oxide of Zn, In, Cd, Sn, combinations of these and the like. An exemplary window material is intrinsic ZnO. (Cooray et. al. Solar Energy Materials and Solar Cells 49 (1997) 291-297) A typical window region may have a thickness in the range from about 1 nm to about 200 nm, preferably about 10 nm to about 150 nm, more preferably about 80 to about 120 nm. The cells will have a topside electrical collection system comprising a front electrode, which serves to collect photogenerated electrons from the photoactive region. The transparent topside electrical contact (also referred to as TCL) is formed over the photoactive region on the light incident surface of the photovoltaic device. The TCL has a thickness in the range from about 10 nm to about 1500 nm, preferably about 100 nm to about 300 nm. The TCL may be a very thin metal film that has transparency to the relevant range of electromagnetic radiation or more commonly is a transparent conductive oxide (TCO). A wide variety of transparent conducting oxides (TCO) or combinations of these may be used. Examples include fluorine-doped tin oxide, tin oxide, indium oxide, indium tin oxide (ITO), aluminum doped zinc oxide (AZO), gallium doped zinc oxide, zinc oxide, combinations of these, and the like (for suvey of TCO matierals, see Gordon, MRS Bull 25 52-57, 2000). In one illustrative embodiment, the TCL region is indium tin oxide. The TCL, which may be a single layer or formed from multiple sublayers, are conveniently formed via sputtering or other suitable deposition technique. (A.F. da Cunha et al. / Journal of Non-Crystalline Solids 352 (2006) 1976-1980)

In many cases, the transparent conductive layer may not be conductive enough to enable sufficient collection of electrons from the device and serve independently as a frontside electrical collection system. Thus, the front electrode region may also comprise an electrical collector 12 (often a grid or mesh of thin wires or lines) formed over the transparent contact layer. The grid region desirably at least includes conductive metals (e.g. as metal particles or wires) such as nickel, copper, silver, gold, aluminum, tin, and the like and/or combinations thereof. In one illustrative embodiment, the grid comprises silver particles in an organic matrix. Since these materials are not transparent, in one illustrative embodiment they are deposited as a grid or mesh of spaced apart lines so that the grid occupies a relatively small footprint on the surface (e.g., in some embodiments, the grid occupies about 10% or less, even about 5% or less, or even about 2% or less of the total surface area associated with light capture to allow the photoactive materials to be exposed to incident light). The grid or mesh is selected such that its metallurgy is the same or similar to the backsurface of the backside substrate and to the outer surface of the electrical connectors. The grid region can be formed by one of several known methods including but not limited to screen printing, ink jet printing, electroplating, sputtering, evaporating and the like. Alternatively, the electrical collection system 12 can be applied to the frontside of the cell as a series of thin wires, or a continuous sheet of thin wires, such as a wire mesh. In one embodiment, the outer surfaces of the wire or mesh can be coated or plated with silver.

The grid electrical collection system may itself extend beyond the top edge of a cell to be contacted with the backside of an adjacent cell thus itself forming the electrical connector. For example, the frontside electrical collection system 12 may be provided in the form of a wire mesh or plurality of thin wires, that extend beyond one edge of the front side of the PV cell. The extended portion of the frontside electrical collection system 12 can be used as the interconnect element 13 to contact the backside electrode of the adjacent cell. Conductive adhesives 15 and 16 can be optionally used to adhere the wires or wire mesh to the TCL 26 and/or the backside electrode. More preferably, as shown in Figs. 1 and 2 additional interconnect element(s) 13 that can be in the form of one or more thin wires or ribbons or wire mesh are provided. The interconnect element(s) 13 contact and make electrical connection to one or both of the transparent contact layer and the electrical collection system 12 of the front electrode region of the cell. On the backside of an adjacent cell, the interconnect elements 13 contact and make electrical connection to the backside electrode 14. The interconnect elements are comprised of one or more conductive metals such as Cu, Ag, Sn, Al, Au, Fe:Ni, W, Ti, and the like. In preferred embodiments, the interconnect elements comprise a Cu or Fe:Ni ribbon that is coated with a thin layer of Ag. The interconnect elements connect adjacent cells and can also be used to connect the cells to external circuitry such as terminal bars. In an exemplary embodiment, the interconnect elements are connected to terminal bars at the leading and trailing edges of the interconnected cell assembly.

It is desirable to limit the amount of shading to the photoactive portion caused by interconnect elements and collection system, while providing enough conductive material to provide electrical continuity that maximizes efficiency of the cell. The interconnect elements 13 can be applied directly to the topside of the cell, in electrical connection with the TCL 26 and/or the electrical collection system 12, and the backside electrode of an adjacent cell. Alternatively, conductive adhesives 15 and/or 16 can be used to make electrical connections and to ensure that the interconnect elements are well adhered to one or both of the front electrode and backside electrode of the cells. The conductive adhesives 15 and 16 should be comprised of substantially the same metal as the interconnect elements and the electrical contact regions of the the front and backside electrodes, or different materials may be used as long as the electrical potential difference between any two electrically connected components is less than about 0.1 V. In preferred embodiments, the conductive adhesives 15, 16 is an electrically conductive adhesive or solder. In exemplary embodiments, conductive material connecting the interconnect elements to both the the front electrode and the backside electrode is an electrically conductive adhesive such as a silver filled epoxy resin.

The electrically conductive adhesives (ECA) may be any such as are known in the industry. Such ECA's are frequently compositions comprising a thermosetting polymer matrix with electrically conductive filler particles. Such thermosetting polymers include but are not limited to thermoset materials having comprising epoxy, cyanate ester, maleimide, phenolic, anhydride, vinyl, allyl or amino functionalities or combinations thereof. The conductive filler particles may be for example silver, gold, copper, nickel, carbon nanotubes, graphite, tin, tin alloys, bismuth or combinations thereof, Epoxy based ECAs with silver particles are preferred. The conductive filler is selected to be the same or similar to the metals in the backside surface of the backside subrate and the outer surface of the electrical connector elements.

In another aspect of the invention, the photovoltaic article or interconnected cell assembly may be connected to terminal bars at one or both ends of the string, or at other regions as necessary to connect the module to external circuitry. In an exemplary embodiment, an interconnect element is connected from the backside electrode of the first photovoltaic cell to a terminal bar at the leading edge of the interconnected assembly, and an interconnect element is also connected from the topside electrode of the last photovoltaic cell to a terminal bar at the trailing edge of the interconnected assembly. It is contemplated that the connection may be created and/or maintained between the interconnect element and the terminal bar via a wide variety of joining techniques including but not limited to welding, soldering, or electrically conductive adhesive. The invention described herein can further be extended to electrical connections of interconnect elements 13 to terminal bars, so that the interconnect elements 13, the terminal bars and any optional adhesives used for electrical connection are comprised of substantially the same metal as the interconnect elements and the electrical contact regions of the the front and backside electrodes, or different materials may be used as long as the electrical potential difference between any two electrically connected components is less than about 0.1 V.

It is contemplated that the photovoltaic article may further comprise optional encapsulant layers that may perform several functions. For example, the encapsulant layers may serve as a bonding mechanism, helping hold the adjacent layers of the module together. It should also allow the transmission of a desirous amount and type of light energy to reach the photovoltaic cell (e.g. the photoactive portion). The encapsulant layers may also function to compensate for irregularities in geometry of the adjoining layers or translated through those layers (e.g. thickness changes). It also may serve to allow flexure and movement between layers due to environmental factors (e.g. temperature change, humidity, etc.) and physical movement and bending. In a preferred embodiment, first encapsulant layer may consist essentially of an adhesive film or mesh, but is preferably a thermoplastic material such as EVA (ethylene-vinyl-acetate), thermoplastic polyolefin or similar material. It is contemplated that the encapsulant layers may be comprised of a single layer or may be comprised of multiple layers (e.g. a first, second, third, fourth, fifth layer, etc. The preferred thickness of this layer can range from about 0.1mm to 1.0mm, more preferably from about 0.2mm to 0.8mm, and most preferably from about 0.25mm to 0.5mm.

Additional front and backside barrier layers may also be used. Frontside barriers must be selected from transparent or translucent materials. These materials may be relatively rigid or may be flexible. Glass is highly useful as a frontside environmental barrier to protect the active cell components from moisture, impacts and the like. A backside barrier or backsheet may also be used; it is preferably constructed of a flexible material (e.g. a thin polymeric film, a metal foil, a multi-layer film, or a rubber sheet). In a preferred embodiment, the back sheet material may be moisture impermeable and also range in thickness from about 0.05mm to 10.0 mm, more preferably from about 0.1mm to 4.0mm, and most preferably from about 0.2mm to 0.8mm. Other physical characteristics may include: elongation at break of about 20% or greater (as measured by ASTM D882); tensile strength or about 25MPa or greater (as measured by ASTM D882); and tear strength of about 70kN/m or greater (as measured with the Graves Method). Examples of preferred materials include glass plate, aluminum foil, Tedlar® (a trademark of DuPont) or a combination thereof. A supplemental barrier sheet which is connectively located below the back sheet. The supplemental barrier sheet may act as a barrier, protecting the layers above from environmental conditions and from physical damage that may be caused by any features of the structure to which the PV device is subjected (e.g. for example, irregularities in a roof deck, protruding objects or the like). It is contemplated that this is an optional layer and may not be required. Alternately the protective layer could be comprised of more rigid materials so as to provide additional roofing function under structural and environmental (e.g. wind) loadings. Additional rigidity may also be desirable so as to improve the coefficient of thermal expansion of the PV device and maintain the desired dimensions during temperature fluctuations. Examples of protective layer materials for structural properties include polymeric materials such polyolefins, polyester amides, polysulfone, acetel, acrylic, polyvinyl chloride, nylon, polycarbonate, phenolic, polyetheretherketone, polyethylene terephthalate, epoxies, including glass and mineral filled composites or any combination thereof.

In addition to the encapsulant and barrier materials, a framing material may also be provided to enable attachment of the photovoltaic article to structures such as buildings and to enable and protect electrical interconnects between articles and from articles to other electrical devices. See for example the frame, preferably prepared by injection molding around a laminate structure, to form a building integrated photovoltaic device as shown in WO 2009/137353.

### Example 1 - Comparative

CIGS cells of 100 X 210 mm dimension comprising a silver screen printed grid (electrical collection system) on the topside and a conductive substrate electrode with Mo coated back contact were obtained. A silver filled electrically conductive adhesive (ECA), DB1541-S from Engineered Conductive Materials, was applied using a spatula in a straight line through a stencil. The deposited ECA line was approximately 2 mm X 90 mm and was equally applied in three regions on the Ag screen printed buss bars on the topside electrode of the cell. The stencil was removed and a Sn coated metal ribbon was placed on top of each of the ECA dispense regions along the length of the ECA such that one end of the ribbon extended beyond the edge of the cell. A small piece of high temperature polyimide tape was applied at the cell edge under the ribbon to avoid contact of the ribbon with the edge of the cell. A second long piece of high temperature polyimide tape was applied was applied along the length of the ribbon to hold the ribbons in place until the ECA was cured. A second silver filled electrically conductive adhesive (ECA), CE3103WLV from Emerson and Cummings, was applied using a spatula in a straight line through a stencil. The deposited ECA line was approximately 2 mm X 75 mm and was equally applied in three regions on the backside electrode of the cell. The stencil was removed and a Sn coated metal ribbon was placed on top of each of the ECA dispense regions along the length of the ECA such that one end of the ribbon extended beyond the edge of the cell. A long piece of high temperature polyimide tape was applied was applied along the length of the ribbon to hold the ribbons in place until the ECA was cured. All interconnect ribbons were 2.5 mm wide and had a thickness of approximately 0.1 mm. The cells were then placed between two pieces of tempered glass and placed in a laboratory oven that was pre-heated to 180°C. The cells were left in the oven for 40 minutes to allow a controlled cure for the ECA. After 40 minutes, the samples were removed from the oven and the polyimide tape was removed from each of the ribbons.

The cells were then laid up into a pre-laminate format in the following order: Glass/polyolefin encapsulant/cell/polyolefin encapsulant/backsheet/polyolefin encapsulant/TPO. The pre-laminate was then laminated in a clamshell type laminator at 150°C. After the laminates were formed, the solar cell laminates were placed into environmental exposure chambers for stability testing. The photovoltaic performance figures of merit obtained at various intervals during damp heat exposure at 85°C and 85% relative humidity conditions are shown in the table below (sample size of 6):

| Exposure Hours | Normalized Pmax | Normalized Rs |
|---|---|---|
| 0 | 1.00 | 1.00 |
| 242 | 1.00 | 1.01 |
| 467 | 0.99 | 1.11 |
| 1117 | 0.97 | 1.12 |
| 1896 | 0.91 | 1.21 |
| 3443 | 0.88 | 1.13 |

Module electrical performance is mathematically extracted from a current-voltage (I-V) characteristic curve that is measured prior to environmental exposure and at various intervals using a Spire 4600 class AAA solar simulator under AM1.5,1000 Watt/m². During the I-V characteristic measurement, the temperature of the module is maintained at 25°C. The I-V characteristic measurement apparatus and procedure meet the requirements specified in the IEC 60904 (parts 1 - 10) and 60891 standards. Immediately following this measurement the devices are returned to the ambient heat environment for the next test period. This process is repeated for each time period. For each I-V measurement, electrical contact is established at the electrical connectors attached to the terminal bars at the leading and trailing ends of the electrical assembly. The power is measured by varying the resistive load between open and closed circuit. The maximum power (Pmax) is calculated as the area of the largest rectangle under the current-voltage (I-V) characteristic curve. The series resistance (Rs) is the slope of the line near open-circuit voltage (Voc), not taken from a diode fit.

### Example 2

CIGS cells of 100 X 210 mm dimension comprising a Silver screen printed grid (electrical collection system) on the topside and a conductive substrate electrode with Mo coated back contact were obtained. The backside electrode was plated with a thin layer of silver using a sputtering technique. A silver filled electrically conductive adhesive (ECA), DB1541-S from Engineered Conductive Materials, was applied using a spatula in a straight line through a stencil. The deposited ECA line was approximately 2 mm X 90 mm and was equally applied in three regions on the Ag screen printed buss bars on the topside electrode of the cell. The stencil was removed and a Ag coated metal ribbon was placed on top of each of the ECA dispense regions along the length of the ECA such that one end of the ribbon extended beyond the edge of the cell. A small piece of high temperature polyimide tape was applied at the cell edge under the ribbon to avoid contact of the ribbon with the edge of the cell. A second long piece of high temperature polyimide tape was applied was applied along the length of the ribbon to hold the ribbons in place until the ECA was cured. A second silver filled electrically conductive adhesive (ECA), CE3103WLV from Emerson and Cummings, was applied using a spatula in a straight line through a stencil. The deposited ECA line was approximately 2 mm X 75 mm and was equally applied in three regions on the Ag plated backside electrode of the cell. The stencil was removed and a Ag coated metal ribbon was placed on top of each of the ECA dispense regions along the length of the ECA such that one end of the ribbon extended beyond the edge of the cell. A long piece of high temperature polyimide tape was applied was applied along the length of the ribbon to hold the ribbons in place until the ECA was cured. All interconnect ribbons were 2.5 mm wide and had a thickness of approximately 0.1 mm. The cells were then placed between two pieces of tempered glass and placed in a laboratory oven that was pre-heated to 180°C. The cells were left in the oven for 40 minutes to allow a controlled cure for the ECA. After 40 minutes, the samples were removed from the oven and the polyimide tape was removed from each of the ribbons.

The cells were then laid up into a pre-laminate format in the following order: Glass/polyolefin encapsulant/cell/polyolefin encapsulant/backsheet/polyolefin encapsulant/TPO. The pre-laminate was then laminated in a clamshell type laminator at 150°C. After the laminates were formed, the solar cell laminates were placed into environmental exposure chambers for stability testing. The photovoltaic performance figures of merit obtained at various intervals during damp heat exposure at 85°C and 85% relative humidity conditions are shown in the table below (sample size of 7):

| Exposure Hours | Normalized Pmax | Normalized Rs |
|---|---|---|
| 0 | 1.00 | 1.00 |
| 259 | 1.08 | 0.80 |
| 596 | 1.10 | 0.88 |
| 901 | 1.13 | 0.90 |
| 1254 | 1.13 | 0.90 |
| 1727 | 1.14 | 0.90 |
| 2794 | 1.01 | 1.05 |
| 3797 | 0.95 | 1.10 |

## Claims

1. A photovoltaic article comprising:
i)a photovoltaic cell (11) comprising
a. an electrically conductive substrate serving as a backside electrode (14) for the photovoltaic cell,
b. a photoactive portion on a frontside of the substrate wherein the photoactive portion comprises a IB-IIIA chalcogenide, , and
c. a front side electrical collection system (12) on the opposite side of the photoactive portion from the substrate,
wherein the backside of the substrate is plated with a metal which forms the backside surface of the substrate;
ii) at least one first electrical connection element (13) having an outer surface which element is electrically connected to a backside surface of the substrate
iii) at least one second electrical connection element (13) having an outer surface which element is electrically connected to the front side electrical collection system, wherein the metal that forms the backside surface of the substrate, any metal surfaces that are part of the front-side electrical collection system, and the outer surfaces of the electrical connection elements each are formed from materials having electric potentials that differ by no more than 0.1 volt with the material used on the other surfaces.

2. The article of claim 1 wherein the front side electrical collection system comprises a metal grid.

3. The article of either of claims 1 and 2 wherein at least one of the first and second electrical connection element is joined to at least one of the backside surface or the frontside electrical collection system using an electrically conductive adhesive (15, 16) which comprises metal particles in a polymer matrix wherein the metal particles have an outer surface of a material with an electric potential that differs by no more than 0.1 volt from the metal that forms the backside surface of the substrate, any metal surfaces that are part of the front-side electrical collection system, and the outer surfaces of the electrical connection elements.

4. The article of any one of claims 1-3 wherein there are at least two adjacent such photovoltaic cells and the at least one first electrical connection element having an outer surface which element is joined to a backside surface of the substrate of one cell is joined to the frontside electrical collection system of the adjacent cell.

5. The article of any one of claims 1-4 wherein the backside surface of the substrate, any metal surfaces that are part of the front-side electrical collection system, and the outer surfaces of the electrical connection elements each are made of the same metal or same metal alloy.

6. The article of claim 5 wherein the metal is silver.

7. The article of any one of the previous claims wherein the frontside electrical collection system comprises a wire mesh that extends beyond the edge of the cell to join the backside of an adjacent cell such that it serves as one of the first or second electrical connection elements.

8. The article of any one of claims 1-6 wherein the second electrical connection element comprises one or more ribbons that extend to the backside of an adjacent cell.

## Patentansprüche

1. Ein Photovoltaikartikel, beinhaltend:
i) eine Photovoltaikzelle (11), beinhaltend
a. ein elektrisch leitfähiges Substrat, das als eine Rückseitenelektrode (14) für die Photovoltaikzelle dient,
b. einen photoaktiven Teil auf einer Vorderseite des Substrats, wobei der photoaktive Teil ein IB-IIIA-Chalkogenid beinhaltet, und
c. ein Vorderseiten-Stromsammelsystem (12) auf der entgegengesetzten Seite des photoaktiven Teils zu dem Substrat,
wobei die Rückseite des Substrats mit einem Metall plattiert ist, das die Rückseitenfläche des Substrats bildet;
ii) mindestens ein erstes elektrisches Verbindungselement (13), das eine Außenfläche aufweist, wobei das Element mit einer Rückseitenfläche des Substrats elektrisch verbunden ist;
iii) mindestens ein zweites elektrisches Verbindungselement (13), das eine Außenfläche aufweist, wobei das Element mit dem Vorderseiten-Stromsammelsystem elektrisch verbunden ist, wobei das Metall, das die Rückseitenfläche des Substrats bildet, jegliche Metallflächen, die Teil des Vorderseiten-Stromsammelsystems sind, und die Außenflächen der elektrischen Verbindungselemente jeweils aus Materialien geformt sind, die elektrische Potentiale aufweisen, die sich um nicht mehr als 0,1 Volt von dem Material unterscheiden, das auf den anderen Flächen verwendet wird.

2. Artikel gemäß Anspruch 1, wobei das Vorderseiten-Stromsammelsystem ein Metallgitter beinhaltet.

3. Artikel gemäß einem der Ansprüche 1 und 2, wobei mindestens eines von dem ersten und dem zweiten elektrischen Verbindungselement mit mindestens einer bzw. einem von der Rückseitenfläche oder dem Vorderseiten-Stromsammelsystem unter Verwendung eines elektrisch leitfähigen Klebstoffs (15, 16) zusammengefügt ist, der Metallpartikel in einer Polymermatrix beinhaltet, wobei die Metallpartikel eine Außenfläche aus einem Material mit einem elektrischen Potential aufweisen, das sich um nicht mehr als 0,1 Volt von dem Metall, das die Rückseitenfläche des Substrats bildet, jeglichen Metallflächen, die Teil des Vorderseiten-Stromsammelsystems sind, und den Außenflächen der elektrischen Verbindungselemente unterscheidet.

4. Artikel gemäß einem der Ansprüche 1-3, wobei mindestens zwei benachbarte derartige Photovoltaikzellen vorliegen und das mindestens eine erste elektrische Verbindungselement, das eine Außenfläche aufweist, mit dem Vorderseiten-Stromsammelsystem der benachbarten Zelle zusammengefügt ist, wobei das Element mit einer Rückseitenfläche des Substrats einer Zelle elektrisch verbunden ist.

5. Artikel gemäß einem der Ansprüche 1-4, wobei die Rückseitenfläche des Substrats, jegliche Metallflächen, die Teil des Vorderseiten-Stromsammelsystems sind, und die Außenflächen der elektrischen Verbindungselemente jeweils aus demselben Metall oder derselben Metalllegierung hergestellt sind.

6. Artikel gemäß Anspruch 5, wobei das Metall Silber ist.

7. Artikel gemäß einem der vorhergehenden Ansprüche, wobei das Vorderseiten-Stromsammelsystem ein Drahtgeflecht beinhaltet, das sich über die Kante der Zelle hinaus erstreckt, um mit der Rückseite einer benachbarten Zelle zusammengefügt zu sein, so dass es als eines des ersten oder des zweiten elektrischen Verbindungselements dient.

8. Artikel gemäß einem der Ansprüche 1-6, wobei das zweite elektrische Verbindungselement ein oder mehrere Bänder beinhaltet, die sich zu der Rückseite einer benachbarten Zelle erstrecken.

## Revendications

1. Un article photovoltaïque comprenant :
i) une cellule photovoltaïque (11) comprenant
a. un substrat électroconducteur servant d'électrode de face arrière (14) pour la cellule photovoltaïque,
b. une partie photoactive sur une face avant du substrat, la partie photoactive comprenant un chalcogénure IB-IIIA, et
c. un système de captage d'électricité de face avant (12) situé sur le côté opposé de la partie photoactive par rapport au substrat,
dans lequel la face arrière du substrat est plaquée avec un métal qui forme la surface arrière du substrat ;
ii) au moins un premier élément de connexion électrique (13) ayant une surface externe, cet élément étant électriquement connecté à une surface arrière du substrat
iii) au moins un deuxième élément de connexion électrique (13) ayant une surface externe, cet élément étant électriquement connecté au système de captage d'électricité de face avant, dans lequel le métal formant la surface arrière du substrat, n'importe quelles surfaces métalliques faisant partie du système de captage d'électricité de face avant, et les surfaces externes des éléments de connexion électrique sont chacun constitués de matériaux ayant des potentiels électriques ne différant pas de plus de 0,1 volt par rapport au matériau utilisé sur les autres surfaces.

2. L'article de la revendication 1 dans lequel le système de captage d'électricité de face avant comprend une grille métallique.

3. L'article de l'une ou l'autre des revendications 1 et 2 dans lequel au moins l'un ou l'autre du premier et du deuxième élément de connexion électrique est attaché à au moins l'un ou l'autre de la surface arrière ou du système de captage d'électricité de face avant à l'aide d'un adhésif électroconducteur (15, 16) comprenant des particules métalliques dans une matrice polymère, les particules métalliques ayant une surface externe d'un matériau dont le potentiel électrique ne diffère pas de plus de 0,1 volt par rapport au métal formant la surface arrière du substrat, à n'importe quelles surfaces métalliques faisant partie du système de captage d'électricité de face avant, et aux surfaces externes des éléments de connexion électrique.

4. L'article de l'une quelconque des revendications 1 à 3 dans lequel il y a au moins deux cellules photovoltaïques adjacentes de ce type et cet au moins un premier élément de connexion électrique ayant une surface externe, l'élément qui est attaché à une surface arrière du substrat d'une cellule étant attaché au système de captage d'électricité de face avant de la cellule adjacente.

5. L'article de l'une quelconque des revendications 1 à 4 dans lequel la surface arrière du substrat, n'importe quelle surface métallique faisant partie du système de captage d'électricité de face avant, et les surfaces externes des éléments de connexion électrique sont chacune faites du même métal ou du même alliage métallique.

6. L'article de la revendication 5 dans lequel le métal est l'argent.

7. L'article de l'une quelconque des revendications précédentes dans lequel le système de captage d'électricité de face avant comprend un treillis métallique qui s'étend au-delà du bord de la cellule pour s'attacher à la face arrière d'une cellule adjacente de telle façon qu'il remplit le rôle de l'un ou l'autre du premier ou du deuxième élément de connexion électrique.

8. L'article de l'une quelconque des revendications 1 à 6 dans lequel le deuxième élément de connexion électrique comprend un ou plusieurs rubans qui s'étendent jusqu'à la face arrière d'une cellule adjacente.
